# EUROPEAN PATENT APPLICATION

(11) **EP 2 835 256 A1**
(43) Date of publication of application: **11.02.2015**
(21) Application number: 13771848.2
(22) Date of filing: 19.03.2013
(51) Int. Cl.: B32B 17/10, H01L 31/04

(54) **TRANSPARENT SHEET AND METHOD FOR MANUFACTURING SAME**

(30) Priority: 02.04.2012 JP 2012083847
(71) Applicant: Nitto Denko Corporation, Ibaraki-shi, Osaka 567-8680 (JP)
(72) Inventor: MURASHIGE, Takeshi, Ibaraki-shi Osaka 567-8680 (JP); HATTORI, Daisuke, Ibaraki-shi Osaka 567-8680 (JP); KAMEYAMA, Tadayuki, Ibaraki-shi Osaka 567-8680 (JP)
(74) Representative: Hoffmann Eitle
(86) International application number: PCT/JP2013/057843
(87) International publication number: WO 2013/150892

(57) **Abstract**

Provided is a transparent sheet that is prevented from curling, is excellent in external appearance, prevents the progress of a crack, and the rupture, of its glass, and is excellent in flexibility. A transparent sheet of the present invention includes: an inorganic glass; and a resin film bonded onto one side, or each of both sides, of the inorganic glass through an adhesion layer, in which: the inorganic glass has a thickness of from 35 µm to 100 µm; the adhesion layer has a single-layer thickness of more than 10 µm and (the thickness of the inorganic glass×0.3) µm or less; the adhesion layer has a modulus of elasticity at 25°C of from 1.2 GPa to 10 GPa; and a ratio of a total thickness of the resin film to the thickness of the inorganic glass is from 0.9 to 4.

## Description

### Technical Field

The present invention relates to a transparent sheet and a method of producing the sheet.

### Background Art

In recent years, the weight reductions and thinning of a display element like a flat panel display (FPD: liquid crystal display element, organic EL display element, or the like) and a solar cell have been progressing from the viewpoints of, for example, conveying property, storing property, and design, and an improvement in flexibility has also been demanded. Further, from the viewpoint of productivity, members for the display element and the solar cell have each been required to have such high flexibility that the member can be continuously produced by a roll-to-roll process. A glass substrate has heretofore been used as a transparent substrate to be used in each of the display element and the solar cell in many cases. The glass substrate is excellent in transparency, solvent resistance, gas barrier property, and heat resistance. However, when such flexibility that the glass substrate can be wound in a roll shape is obtained by reducing the weight and thickness of a glass for forming the substrate, a problem arises in that the glass becomes significantly brittle and hence it becomes difficult to handle the substrate.

In order that the handleability of a thin glass substrate may be improved, a substrate obtained by forming a resin layer on a glass surface has been disclosed (for example, Patent Literatures 1 and 2). In addition, as described in Patent Literature 2, a stiff thermoplastic resin is preferred as a resin for forming such resin layer. However, when a resin solution is directly applied onto the glass surface, a problem arises in that the glass substrate is liable to curl owing to the shrinkage of the resin layer upon drying of the resin solution. On the other hand, a method involving bonding the resin film onto the glass surface through an adhesion layer hardly causes the problem of the curling. However, in the case where the resin film is bonded as described above, the following problems arise. When the adhesion layer is thin, an external appearance defect due to foreign matter on the glass surface (such as cullet) is liable to occur, and when the adhesion layer is thick, the stiffness of the resin layer is hardly transmitted to the glass and hence the reinforcing effect of the resin layer on the glass becomes insufficient.

### Citation List

### Patent Literature

[PTL 1] JP 4332579 B2
[PTL 2] JP 2010-132526 A

### Summary of Invention

### Technical Problem

The present invention has been made to solve the related-art problems, and an object of the present invention is to provide a transparent sheet that is prevented from curling, is excellent in external appearance, prevents the progress of a crack, and the rupture, of its glass, and is excellent in flexibility.

### Solution to Problem

A transparent sheet of the present invention includes: an inorganic glass; and a resin film bonded onto one side, or each of both sides, of the inorganic glass through an adhesion layer, in which: the inorganic glass has a thickness of from 35 µm to 100 µm; the adhesion layer has a single-layer thickness of more than 10 µm and (the thickness of the inorganic glass×0.3) µm or less; the adhesion layer has a modulus of elasticity at 25°C of from 1.2 GPa to 10 GPa; and a ratio of a total thickness of the resin film to the thickness of the inorganic glass is from 0.9 to 4.

In a preferred embodiment, the modulus of elasticity of the resin film at 25°C is from 1.5 GPa to 10 GPa.

In a preferred embodiment, the resin film contains a resin having a glass transition temperature of from 150°C to 350°C.

In a preferred embodiment, the resin film contains a thermoplastic resin.

In a preferred embodiment, the adhesion layer is formed of a UV-curable resin.

In a preferred embodiment, the transparent sheet of the present invention has a total thickness of 150 µm or less.

In a preferred embodiment, the transparent sheet of the present invention is used as a substrate for a display element or for a solar cell.

According to another aspect of the present invention, there is provided a method of producing a transparent sheet. Theproduction method includes the steps of: applying a resin solution for forming an adhesion layer onto an inorganic glass or a resin film to form an applied layer; and laminating the inorganic glass and the resin film through the applied layer, followed by curing of the applied layer to form an adhesion layer to bond the inorganic glass and the resin film onto each other, in which: the inorganic glass has a thickness of from 35 µm to 100 µm; the adhesion layer has a single-layer thickness of more than 10 µm and (the thickness of the inorganic glass×0.3) µm or less; the adhesion layer has a modulus of elasticity at 25°C of from 1.2 GPa to 10 GPa; and a ratio of a total thickness of the resin film to the thickness of the inorganic glass is from 0.9 to 4.

### Advantageous Effects of Invention

According to one embodiment of the present invention, the following transparent sheet can be provided. The transparent sheet includes the resin film having a specific thickness on one side, or each of both sides, of the inorganic glass, and includes the adhesion layer having a specific thickness and a specific modulus of elasticity between the inorganic glass and the resin film, and hence even when the inorganic glass and the resin film are bonded onto each other through the adhesion layer, the sheet is excellent in external appearance, prevents the progress of a crack, and the rupture, of the glass, and is excellent in flexibility. In addition, the transparent sheet of the present invention is prevented from curling by bonding the inorganic glass and the resin film onto each other through the adhesion layer.

### Brief Description of Drawings

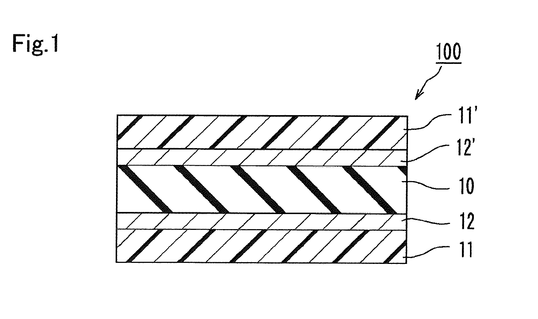

FIG. 1 is a schematic sectional view of a transparent sheet according to a preferred embodiment of the present invention.

### Description of Embodiments

### A. Entire construction of transparent sheet

FIG. 1 is a schematic sectional view of a transparent sheet according to a preferred embodiment of the present invention. A transparent sheet 100 of FIG. 1 includes an inorganic glass 10 and resin films 11, 11' placed on one side, or each of both sides, of the inorganic glass 10 (preferably on each of both sides like the illustrated example) and includes adhesion layers 12, 12' between the inorganic glass 10 and the resin films 11, 11'. Although not shown, the transparent sheet can include any appropriate other layer on the side of the resin film opposite to the inorganic glass as required. Examples of the other layer include a transparent conductive layer and a hard coat layer.

The total thickness of the transparent sheet is preferably 150 µm or less, more preferably 140 µmor less , particularly preferably from 80 µm to 135 µm. According to the present invention, the resin film is provided as described above, and hence the thickness of the inorganic glass can be markedly reduced as compared with that of a conventional glass substrate.

The thickness of the inorganic glass is from 35 µm to 100 µm, preferably from 40 µm to 80 µm, more preferably from 45 µm to 70 µm. In the present invention, the following transparent sheet can be obtained: the transparent sheet has the resin film on one side, or each of both sides, of the inorganic glass, and hence even when the thickness of the inorganic glass is reduced, the sheet is excellent in impact resistance.

The single-film thickness of the resin film is preferably from 16 µm to 400 µm, more preferably from 20 µm to 200 µm, particularly preferably from 30 µm to 150 µm, most preferably from 30 µm to 80 µm. When the resin film is placed on each of both sides of the inorganic glass, the thicknesses of the respective resin films may be identical to or different from each other. The thicknesses of the respective resin films are preferably identical to each other. Further, the respective resin films may be formed of the same resin or of resins having the same characteristics, ormaybe formedof different resins. The respective resin films are preferably formed of the same resin. Therefore, the respective resin films are most preferably formed of the same resin so as to have the same thickness. With such construction, even when the transparent sheet is subjected to heat treatment, a thermal stress is uniformly applied to both surfaces of the inorganic glass, and hence it becomes extremely difficult for the warping or undulation of the sheet to occur.

The ratio of the total thickness of the resin film to the thickness of the inorganic glass is from 0.9 to 4, preferably from 0.9 to 3, more preferably from 0.9 to 2.2. When the ratio of the total thickness of the resin film falls within such range, a transparent sheet excellent in bending property can be obtained. It should be noted that when the transparent sheet of the present invention includes the resin films on both sides of the inorganic glass, the phrase "total thickness of the resin film" as used herein means the sum of the thicknesses of the respective resin films.

A lower limit for the single-layer thickness of the adhesion layer is more than 10 µm, preferably more than 11 µm. An upper limit for the single-layer thickness of the adhesion layer is (the thickness of the inorganic glass×0.3) µm or less, preferably less than (the thickness of the inorganic glass×0.25) µm. When the single-layer thickness of the adhesion layer falls within such range, the inorganic glass and the resin film can be satisfactorily brought into close contact with each other. In addition, a transparent sheet excellent in external appearance and excellent in impact resistance as a result of satisfactory reinforcement of the inorganic glass can be obtained. In a preferred embodiment, the single-layer thickness of the adhesion layer is more than 10 µm and 20 µm or less. In a more preferred embodiment, the single-layer thickness of the adhesion layer is more than 10 µm and 15 µm or less.

The rupture diameter of the transparent sheet when cracked and bent is preferably 50 mm or less, more preferably 40 mm or less, particularly preferably 30 mm or less.

The radius of curvature of a transparent sheet including the resin film only on one side of the inorganic glass and having sizes measuring 30 mm wide by 125 mm long is preferably 1,000 mm or more, more preferably 2,000 mm or more. The transparent sheet of the present invention is suppressed in curling by bonding the inorganic glass and the resin film onto each other through the adhesion layer.

The light transmittance of the transparent sheet at a wavelength of 550 nm is preferably 80% or more, more preferably 85% or more. The reduction ratio of light transmittance of the transparent sheet after heat treatment at 180°C for 2 hours is preferably within 5%. This is because, with such reduction ratio, for example, the practically allowable light transmittance can be kept, even if heat treatment required in a production process of display elements and solar cells is conducted.

The transparent sheet has a coefficient of linear expansion of preferably 15 ppm/°C or less, more preferably 10 ppm/°C or less, particularly preferably from 1 ppm/°C to 10 ppm/°C. The transparent sheet shows excellent dimensional stability (e.g., a coefficient of linear expansion within such a range as described above) because the transparent sheet includes the inorganic glass.

### B. Inorganic glass

As the inorganic glass to be used in the transparent sheet of the present invention, any appropriate glass can be adopted as long as the glass is in a plate shape. Examples of the inorganic glass include soda-lime glass, borate glass, aluminosilicate glass, and quartz glass according to the classification based on a composition. Further, according to the classification based on an alkali component, alkali-free glass and low alkali glass are exemplified. The content of an alkali metal component (e.g., Na₂O, K₂O, Li₂O) of the inorganic glass is preferably 15 wt% or less, more preferably 10 wt% or less.

The light transmittance of the inorganic glass at a wavelength of 550 nm is preferably 85% or more. The refractive index of the inorganic glass at a wavelength of 550 nm is preferably from 1.4 to 1.65.

The density of the inorganic glass is preferably from 2.3 g/cm³ to 3.0 g/cm³, more preferably from 2.3 g/cm³ to 2.7 g/cm³. With the inorganic glass in the range, a light-weight transparent sheet is obtained.

As a method of forming the inorganic glass, any appropriate method can be adopted. Typically, the inorganic glass is produced by melting a mixture containing a main material such as silica and alumina, an antifoaming agent such as salt cake and antimony oxide, and a reducing agent such as carbon at a temperature of from 1, 400°C to 1, 600°C to form a thin plate, followed by cooling. Examples of the method of forming a thin plate of the inorganic glass include a slot down draw method, a fusion method, and a float method. The inorganic glass formed into a plate shape by those methods maybe chemicallypolishedwitha solvent such as hydrofluoric acid, if required, in order to reduce the thickness and enhance smoothness.

As the inorganic glass, commercially available inorganic glass may be used as it is, or commercially available inorganic glass may be polished so as to have a desired thickness. Examples of the commercially available inorganic glass include "7059" , "1737" , or "EAGLE 2000" manufactured by Corning Incorporated, "AN100" manufactured by Asahi Glass Co. , Ltd. , "NA-35" manufactured by NH Technoglass Corporation, "OA-10" manufactured by Nippon Electric Glass Co. , Ltd. , and "D263" or "AF45" manufactured by SCHOTT AG.

### C. Resin film

The resin film has amodulus of elasticity at 25°C of preferably from 1.5 GPa to 10 GPa, more preferably from 1.7 GPa to 8 GPa, particularly preferably from 1. 9 GPa to 6 GPa. As long as the modulus of elasticity of the resin film falls within such range, even when the inorganic glass is made thin, the resin film alleviates a local stress in the direction in which the inorganic glass is torn toward a defect at the time of the deformation. Accordingly, the inorganic glass hardly cracks or ruptures.

The resin film has a fracture toughness value at 25°C of from 1.5 MPa·m^{1/2} to 10 MPa·m^{1/2}, preferably from 2 MPa·m^{1/2} to 6 MPa·m^{1/2}, more preferably from 2 MPa·m^{1/2} to 5 MPa·m^{1/2}. As long as the fracture toughness value falls within such range, the resin film has sufficient toughness, and hence a transparent sheet in which the inorganic glass is reinforced so that the progress of a crack in the inorganic glass and the rupture of the inorganic glass may be prevented and which is excellent in bending property can be obtained. In addition, even if the inorganic glass ruptures in the transparent sheet, the resin film hardly ruptures, and hence the scattering of the inorganic glass is prevented by the resin film and the shape of the transparent sheet is maintained. Accordingly, the contamination of facilities in production steps for display elements and solar cells can be prevented, and an improvement in yield can be achieved.

The resin film preferably has a light transmittance at a wavelength of 550 nm of 80% or more. The resin film preferably has a refractive index at a wavelength of 550 nm of from 1.3 to 1.7.

Any appropriate resin can be adopted as a material for forming the resin film as long as an effect of the present invention is obtained. Examples of the resin include a thermoplastic resin and a curable resin that cures with heat or an active energy ray. The resin is preferably a thermoplastic resin. Specific examples of the resin include: a polyether sulfone-based resin; a polycarbonate-based resin; an acrylic resin; polyester-based resins such as polyethylene terephthalate and polyethylene naphthalate; a polyolefin-based resin; cycloolefin-based resins such as a norbornene-based resin; a polyimide-based resin; a polyamide-based resin; a polyimideamide-based resin; a polyarylate-based resin; a polysulfone-based resin; and a polyether imide-based resin.

The resin in the resin film has a glass transition temperature of preferably from 150°C to 350°C, more preferably from 180°C to 320°C, particularly preferably from 210°C to 290°C. A transparent sheet excellent in heat resistance can be obtained as long as the glass transition temperature of the resin in the resin film falls within such range.

The resin film preferably contains a thermoplastic resin (A) having repeating units represented by the following general formula (1) and/or the following general formula (2). The resin film containing the thermoplastic resin (A) is excellent in adhesiveness with the adhesion layer and is also excellent in toughness. A transparent sheet in which a crack hardly progresses at the time of cutting can be obtained through the use of such resin film. In addition, fluctuations in dimensions of the resin film containing the thermoplastic resin (A) excellent in adhesiveness with the adhesion layer are small because the resin film is strongly restrained by the inorganic glass. As a result, the transparent sheet including the resin film containing the thermoplastic resin (A) shows excellent dimensional stability. 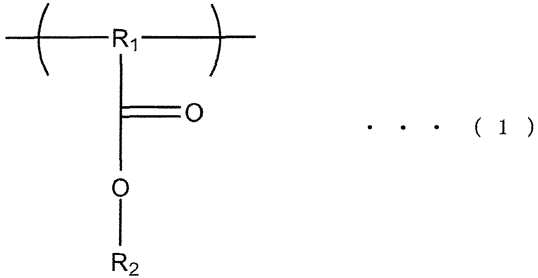 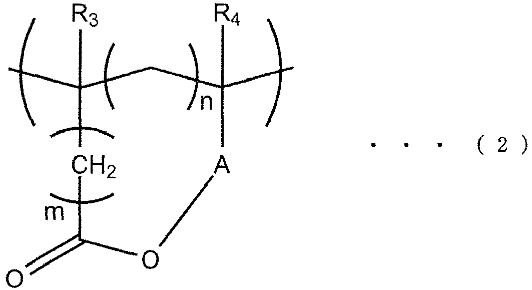 In the formula (1): R₁ represents a substituted or unsubstituted aromatic hydrocarbon group having 6 to 24 carbon atoms, an alicyclic hydrocarbon group having 4 to 14 carbon atoms, or a linear or branched aliphatic hydrocarbon group having 1 to 8 carbon atoms, preferably a substituted or unsubstituted aromatic hydrocarbon group having 6 to 20 carbon atoms, an alicyclic hydrocarbon group having 4 to 12 carbon atoms, or a linear or branched aliphatic hydrocarbon group having 1 to 6 carbon atoms, more preferably a substituted or unsubstitutedaromatic hydrocarbon group having 6 to 18 carbon atoms, an alicyclic hydrocarbon group having 5 to 10 carbon atoms, or a linear or branched aliphatic hydrocarbon group having 1 to 4 carbon atoms; and R₂ represents a substituted or unsubstituted aromatic hydrocarbon group having 6 to 24 carbon atoms, a linear or branched aliphatic hydrocarbon group having 1 to 8 carbon atoms, an alicyclic hydrocarbon group having 5 to 12 carbon atoms, or a hydrogen atom, preferably a substituted or unsubstituted aromatic hydrocarbon group having 6 to 20 carbon atoms, a linear or branched aliphatic hydrocarbon group having 1 to 6 carbon atoms, an alicyclic hydrocarbon group having 5 to 10 carbon atoms, or a hydrogen atom. In the formula (2): R₃ and R₄ each independently represent a linear or branched aliphatic hydrocarbon group having 1 to 8 carbon atoms, a hydrogen atom, or an alicyclic hydrocarbon group having 5 to 12 carbon atoms, preferably a linear or branched aliphatic hydrocarbon group having 1 to 5 carbon atoms, a hydrogen atom, or an alicyclic hydrocarbon group having 5 to 10 carbon atoms, more preferably a linear or branched aliphatic hydrocarbon group having 1 to 4 carbon atoms, a hydrogen atom, or an alicyclic hydrocarbon group having 5 to 8 carbon atoms; A represents a carbonyl group or a linear or branched aliphatic hydrocarbon group having 1 to 8 carbon atoms, preferably a carbonyl group or a linear or branched aliphatic hydrocarbon group having 1 to 6 carbon atoms, more preferably a carbonyl group or a linear or branched aliphatic hydrocarbon group having 1 to 4 carbon atoms; m represents an integer of from 0 to 8, preferably an integer of from 0 to 6, more preferably an integer of from 0 to 3; and n represents an integer of from 0 to 4, preferably an integer of from 0 to 2.

The thermoplastic resin (A) has a polymerization degree of preferably from 10 to 6,000, more preferably from 20 to 5,000, particularly preferably from 50 to 4,000.

Specific examples of the thermoplastic resin (A) include styrene-maleic anhydride copolymers and ester group-containing cycloolefin polymers. One kind of those thermoplastic resins may be used alone, or two or more kinds of them may be used as a mixture.

The resin film preferably contains a thermoplastic resin (B) having one or more repeating units represented by the following general formula (3). The resin film containing the thermoplastic resin (B) is excellent in adhesiveness with the adhesion layer and is also excellent in toughness. A transparent sheet in which a crack hardly progresses at the time of cutting can be obtained through the use of such resin film. In addition, fluctuations in dimensions of the resin film containing the thermoplastic resin (B) excellent in adhesiveness with the adhesion layer are small because the resin film is strongly restrained by the inorganic glass. As a result, the transparent sheet including the resin film containing the thermoplastic resin (B) shows excellent dimensional stability. 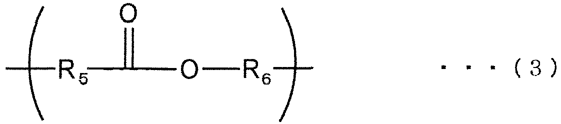 In the formula (3): R₅ represents a substituted or unsubstituted aromatic hydrocarbon group having 6 to 24 carbon atoms, a linear or branched aliphatic hydrocarbon group having 1 to 8 carbon atoms, an alicyclic hydrocarbon group having 4 to 14 carbon atoms, or an oxygen atom, preferably a substituted or unsubstituted aromatic hydrocarbon group having 6 to 20 carbon atoms, a linear or branched aliphatic hydrocarbon group having 1 to 6 carbon atoms, an alicyclic hydrocarbon group having 4 to 12 carbon atoms, or an oxygen atom, more preferably a substituted or unsubstituted aromatic hydrocarbon group having 6 to 18 carbon atoms, a linear or branched aliphatic hydrocarbon group having 1 to 4 carbon atoms, an alicyclic hydrocarbon group having 5 to 10 carbon atoms, or an oxygen atom; and R₆ represents a substituted or unsubstituted aromatic hydrocarbon group having 6 to 24 carbon atoms, a linear or branched aliphatic hydrocarbon group having 1 to 8 carbon atoms, an alicyclic hydrocarbon group having 5 to 12 carbon atoms, or a hydrogen atom, preferably a substituted or unsubstituted aromatic hydrocarbon group having 6 to 20 carbon atoms, a linear or branched aliphatic hydrocarbon group having 1 to 6 carbon atoms, an alicyclic hydrocarbon group having 5 to 10 carbon atoms, or a hydrogen atom.

The thermoplastic resin (B) has a polymerization degree of preferably from 10 to 6,000, more preferably from 20 to 5,000, particularly preferably from 50 to 4,000.

Specific examples of the thermoplastic resin (B) include polyarylate, polyester, and polycarbonate. One kind of those thermoplastic resins may be used alone, or two or more kinds of them may be used as a mixture.

The resin film preferably contains a thermoplastic resin (C) having a hydroxyl group at any one of its terminals. Specific examples of the thermoplastic resin (C) include thermoplastic resins obtained by modifying the terminals of polyimide, polyimideamide, polyether sulfone, polyether imide, polysulfone, polyarylate, and polycarbonate with hydroxylgroups. One kind of those thermoplastic resins may be used alone, or two or more kinds of them may be used as a mixture. The use of any such thermoplastic resin can provide a resin film excellent in toughness. As a result, a transparent sheet in which a crack hardly progresses at the time of cutting can be obtained. It should be noted that any appropriate method can be employed for the modification of the terminals with hydroxyl groups.

The thermoplastic resin (C) has a polymerization degree of preferably from 90 to 6,200, more preferably from 130 to 4,900, particularly preferably from 150 to 3,700.

In terms of polyethylene oxide conversion, the weight-average molecular weight of the thermoplastic resin (C) is preferably from 2.0×10⁴ to 150×10⁴, more preferably from 3×10⁴ to 120×10⁴, particularly preferably from 3.5×10⁴ to 90×10⁴. In the case where the weight-average molecular weight of the thermoplastic resin (C) is less than 2.0×10⁴, the toughness of the resin film becomes insufficient and the reinforcing effect on the inorganic glass may become insufficient. In the case where the weight-average molecular weight of the thermoplastic resin (C) is more than 150×10⁴, its viscosity becomes too high and therefore its handling characteristics may become poor.

The hydroxyl group is preferably a phenolic hydroxyl group.

The content of the hydroxyl group is preferably 0.3 or more, more preferably from 0.5 to 2.0 per a polymerization degree of the thermoplastic resin (C) of 100. As long as the content of the hydroxyl group falls within such range, a thermoplastic resin excellent in reactivity with an epoxy group-terminated coupling agent can be obtained.

When the resin film contains the thermoplastic resin (C), the resin film preferably further contains imidazoles, epoxys, and/or oxetanes. The content of the imidazoles, with respect to the thermoplastic resin (C), is preferably from 0.5 wt% to 5 wt%, more preferably from 1 wt% to 4 wt%. The content of the epoxys, with respect to the thermoplastic resin (C), is preferably from 1 wt% to 15 wt%, more preferably from 3 wt% to 10 wt%. The content of the oxetanes, with respect to the thermoplastic resin (C), is preferably from 0.5 wt% to 10 wt%, more preferably from 1 wt% to 5 wt%.

Examples of the imidazoles include 2-methylimidazole, 2-undecylimidazole, 2-heptadecylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, an epoxy-imidazole adduct, 2,3-dihydro-1H-pyrrolo[1,2-a]benzimidazole, 1-dodecyl-2-methyl-3-benzylimidazolium chloride, 2-phenyl-4,5-hydroxymethylimidazole, 2-phenyl-4-methyl-5-hydroxymethylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, and 2,4-diamino-6-[2'-ethyl-4'-methylimidazolyl-(1')]-ethyl-s-tria zine.

As the epoxys, any appropriate resin can be used as long as the resin has an epoxy group in any one of its molecules. Examples of the epoxys include epoxy-based resins including: bisphenol types such as a bisphenol A type, a bisphenol F type, a bisphenol S type, and hydrogenated products thereof; novolac types such as a phenol novolac type and a cresol novolac type; nitrogen-containing cyclic types such as a triglycidyl isocyanurate type and a hydantoin type; alicyclic types; aliphatic types; aromatic types such as a naphthalene type andabiphenyl type; glycidyl types suchas aglycidyl ether type, a glycidyl amine type, and a glycidyl ester type; dicyclo types such as a dicyclopentadiene type; ester types; ether ester types; and modified types thereof. One kind of these epoxy-based resins may be used alone, or two or more kinds of them may be used as a mixture. The epoxys are preferably a bisphenol A type epoxy-based resin, an alicyclic type epoxy-based resin, a nitrogen-containing cyclic type epoxy-based resin, or a glycidyl type epoxy-based resin.

The oxetanes are preferably compounds each represented by the following general formula (4), (5), or (6).

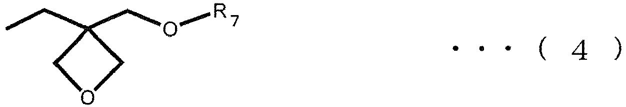

In the formula (4), R₇ represents a hydrogen atom, an alicyclic hydrocarbon group, a phenyl group, a naphthyl group, or an aliphatic hydrocarbon group having 1 to 10 carbon atoms.

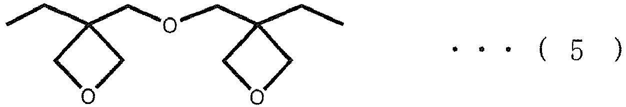

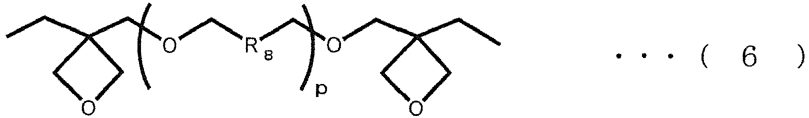

In the formula (6), R₈ represents an alicyclic hydrocarbon group, a phenyl group, a naphthyl group, or an aliphatic hydrocarbon group having 1 to 10 carbon atoms, and p represents an integer of from 1 to 5.

Examples of the oxetanes include 3-ethyl-3-hydroxymethyloxetane (oxetane alcohol), 2-ethylhexyloxetane, xylylenebisoxetane, and 3-ethyl-3(((3-ethyloxetan-3-yl)methoxy)methyl)oxetane.

One kind of the thermoplastic resin (A), the thermoplastic resin (B), and the thermoplastic resin (C) may be used alone, or two or more kinds of them may be used as a mixture.

The resin filmmay be a single layer, ormaybeamultilayer body. In one embodiment, the resin film is a multilayer body having a layer containing the thermoplastic resin (A), and a layer containing a thermoplastic resin free of repeating units represented by the general formulae (1) and (2). In another embodiment, the resin film is a multilayer body having a layer containing the thermoplastic resin (B) and a layer containing a thermoplastic resin free of a repeating unit represented by the general formula (3). As long as the resin film is any such multilayer body, a transparent sheet excellent in mechanical strength and heat resistance can be obtained.

The resin film preferably has chemical resistance. Specifically, the resin film preferably has chemical resistance to a solvent used in, for example, a washing step or resist peeling step upon production of display elements and solar cells. Examples of the solvent used in the washing step or the like upon production of the display elements include isopropyl alcohol, acetone, dimethyl sulfoxide (DMSO), and N-methylpyrrolidone (NMP).

The resin film can further contain any appropriate additive depending on purposes. Examples of the additive include a diluent, an antioxidant, a modifier, a surfactant, a dye, a pigment, a discoloration preventing agent, a UV absorber, a softening agent, a stabilizer, a plasticizer, an antifoaming agent, and a stiffener. The kind, number, and amount of an additive to be contained in the resin film can be set appropriately depending on purposes.

### D. Adhesion layer

The modulus of elasticity of the adhesion layer at 25°C is preferably from 1.2 GPa to 10 GPa, more preferably from 1.5 GPa to 8 GPa, particularly preferably from 2 GPa to 5 GPa. When the modulus of elasticity of the adhesion layer falls within such range, a transparent sheet excellent in bending property and impact resistance as a result of satisfactory reinforcement of the inorganic glass can be obtained.

Any appropriate resin can be adopted as a material for forming the adhesion layer as long as the adhesion layer having the modulus of elasticity as described above can be formed. Examples of the material for forming the adhesion layer include a thermosetting resin and an active energy ray-curable resin. Of those, an active energy ray-curable resin is preferred and a UV-curable resin is particularly preferred. When the active energy ray-curable resin is used, the adhesion layer can be cured without being heated. Accordingly, a transparent sheet that prevents the expansion of the resin film and is hence excellent in surface smoothness can be obtained.

A coupling agent may be added to the adhesion layer. The addition of the coupling agent to the adhesion layer can improve adhesion with the inorganic glass and/or the resin layer.

Specific examples of the resin for forming the adhesion layer include cyclic ethers, silicone-based resins, and acrylic resins each having, for example, an epoxy group, glycidyl group, or oxetanyl group, and mixtures thereof.

### E. Other layer

The transparent sheet can include any appropriate other layer on the side of the resin film opposite to the inorganic glass as required. Examples of the other layer include a transparent conductive layer and a hard coat layer.

The transparent conductive layer can function as an electrode or an electromagnetic wave shield upon use of the transparent sheet as a substrate for a display element or solar cell.

A material that can be used in the transparent conductive layer is, for example, a metal such as copper or silver, a metal oxide such as indium tin oxide (ITO) or indium zinc oxide (IZO), a conductive polymer such as polythiophene or polyaniline, or a composition containing a carbon nanotube.

The hard coat layer has a function of imparting chemical resistance, abrasion resistance, and surface smoothness to the transparent sheet.

Any appropriate material can be adopted as a material for forming the hard coat layer. Examples of the material for forming the hard coat layer include epoxy-based resins, acrylic resins, silicone-based resins, and mixtures thereof. Of those, an epoxy-based resin excellent in heat resistance is preferred. The hard coat layer can be obtained by curing any such resin with heat or an active energy ray.

### F. Method of producing transparent sheet

A method of producing a transparent sheet of the present invention is, for example, a method including: laminating an inorganic glass and a resin film through an applied layer containing a resin solution for forming an adhesion layer; and then curing the applied layer to form an adhesion layer to bond the inorganic glass and the resin film onto each other.

### (Formation of applied layer)

In the production method, first, the resin solution for forming an adhesion layer is applied onto the inorganic glass or the resin film to form the applied layer. The inorganic glass described in the sections A and B can be used as the inorganic glass. The resin film described in the sections A and C can be used as the resin film. The resin described in the section D can be used as a resin in the resin solution for forming an adhesion layer. The resin solution for forming an adhesion layer may contain any appropriate solvent. Examples of the solvent include methyl ethyl ketone, cyclopentanone, and toluene. In addition, the resin solution for forming an adhesion layer can contain any appropriate additive such as a polymerization initiator, a curing agent, a coupling agent, or a photosensitizer.

An inorganic glass and resin film subjected to easy-adhesion treatment may be used as the inorganic glass and the resin film. The performance of the easy-adhesion treatment can improve their adhesive strengths to the adhesion layer. Examples of the easy-adhesion treatment include: non-contact-type surface treatment such as corona treatment or plasma treatment; and coupling agent treatment.

Any appropriate method can be adopted as a method for the coupling treatment. The method is specifically, for example, a method involving applying a solution of the coupling agent onto the surface of the inorganic glass or the resin film, and thermally treating the resultant.

Examples of the coupling agent include an amino-based coupling agent, an epoxy-based coupling agent, an isocyanate-based coupling agent, a vinyl-based coupling agent, a mercapto-based coupling agent, and a (meth)acryloxy-based coupling agent. When the resin film contains a resin having an ester bond, an epoxy-based coupling agent, an amino-based coupling agent, and/or an isocyanate-based coupling agent is preferably used. When the resin film contains a resin having a hydroxyl group, an epoxy-based coupling agent is preferably used.

The amino-based coupling agent is preferably an alkoxy silane having an amino group or a halogenated silane having an amino group, particularly preferably an alkoxy silane having an amino group.

Specific examples of the alkoxy silane having an amino group include 3-aminopropyltrimethoxysilane, 3-aminopropylmethyldimethoxysilane, 3-aminopropyldimethylmethoxysilane, 3-aminopropyltriethoxysilane, 3-aminopropylmethyldiethoxysilane, 3-aminopropylmethyldimethoxysilane, 6-aminohexyltrimethoxysilane, 6-aminohexyltriethoxysilane, 11-aminoundecyltrimethoxysilane, 11-aminoundecyltriethoxysilane, and 3-triethoxysilyl-N-(1,3-dimethyl-butylidene)propylamino.

Specific examples of the halogenated silane having an amino group include 3-aminopropyltrichlorosilane, 3-aminopropylmethyldichlorosilane, 3-aminopropyldimethylchlorosilane, 6-aminohexyltrichlorosilane, and 11-aminoundecyltrichlorosilane.

Specific examples of the epoxy-based coupling agent include 2-(3,4-epoxycyclohexyl)ethyltrimethoxysilane, 3-glycidoxypropyltrimethoxysilane, 3-glycidoxypropylmethyldiethoxysilane, and 3-glycidoxypropyltriethoxysilane.

A specific example of the isocyanate-based coupling agent is 3-isocyanatopropyltriethoxysilane.

Any appropriate solvent can be used as a solvent used upon preparation of the solution of the coupling agent as long as the solvent does not react with the coupling agent. Examples of the solvent include: aliphatic hydrocarbon-based solvents such as hexane and hexadecane; aromatic solvents such as benzene, toluene, and xylene; halogen hydrocarbon-based solvents such as methylene chloride and 1,1,2-trichloroethane; ether-based solvents such as tetrahydrofuran and 1,4-dioxane; alcohol-based solvents such as methanol and propanol; ketone-based solvents such as acetone and 2-butanone; and water.

Any appropriate heat treatment method can be adopted as a heat treatment method in the coupling treatment. A heat treatment temperature is typically from 50°C to 150°C, and a heat treatment time is typically from 1 to 10 minutes. It is possible that the coupling agent and the surface of the inorganic glass are chemically bonded to each other by the heat treatment.

In addition, a resin film subjected to annealing treatment maybe used as the resin film. Impurities suchas a residual solvent and an unreacted monomer component can be efficiently removed by performing the annealing treatment. A temperature for the annealing treatment is preferably from 100 ° C to 200 °C, and a treatment time for the annealing treatment is preferably from 5 minutes to 20 minutes.

A lower limit for the thickness of the applied layer is preferably more than 10 µm, more preferably more than 11 µm. An upper limit for the thickness of the applied layer is preferably less than (the thickness of the inorganic glass×0.5) µm, more preferably less than (the thickness of the inorganic glass×0.4) µm. The thickness of the applied layer can be set so as to be larger than the desired thickness of the adhesion layer in consideration of the amount of the solvent in the resin solution for forming an adhesion layer.

### (Bonding of inorganic glass and resin film)

After the formation of the applied layer, the inorganic glass and the resin film are laminated through the applied layer. After that, the applied layer is cured to bond the inorganic glass and the resin film onto each other. The resin film may be laminated as follows: the film is formed on any appropriate base material in advance and the film is transferred onto the inorganic glass. It should be noted that the timing at which the inorganic glass and the resin film are laminated may be substantially simultaneous with the formation of the applied layer. That is, the inorganic glass and the resin film may be laminated while the resin solution for forming an adhesion layer is supplied to a space between the inorganic glass and the resin film.

A method of curing the applied layer is, for example, a thermal curing method or an active energy ray-curing method. Of those, an active energy ray-curing method is preferably employed and a UV-curing method is more preferably employed. When the applied layer is cured with an active energy ray, the curing does not require heating. Accordingly, a transparent sheet that suppresses the expansion of the resin film and is hence excellent in smoothness of a resin film surface can be obtained.

Typical conditions for the UV irradiation in the UV-curing method are as described below. An irradiation cumulative light quantity is from 100 mJ/cm² to 2,000 mJ/cm², and an irradiation time is from 5 minutes to 30 minutes. It should be noted that the applied layer may be semi-cured after the formation of the applied layer by the application of the resin solution for forming an adhesion layer onto the surface of the inorganic glass or resin film and before the lamination of the inorganic glass and the resin film. The semi-curing can be performed by, for example, applying UV light at from 1 mJ/cm² to 10 mJ/cm² for from 1 second to 60 seconds.

Typical conditions for the heat treatment in the thermal curving method are as described below. A heating temperature is from 100°C to 200°C, and a heating time is from 5 minutes to 30 minutes.

### G. Use

The transparent sheet of the present invention can be suitably used as a substrate for a display element or for a solar cell. The transparent sheet of the present invention can also be suitably used as a moisture-proof sheet for a substrate for a display element or for a solar cell. Examples of the display element include a liquid crystal display, a plasma display, and an organic EL display.

### Examples

Hereinafter, the present invention is described specifically by way of Examples. However, the present invention is not limited to Examples below. It should be noted that a thickness was measured using a digital micrometer "KC-351C type" manufactured by Anritsu Corporation.

### [Example 1]

A casting solution (A) was obtained by mixing polyarylate (U-Polymer U-100 manufactured by Unitika Limited), trichloroethane, and a leveling agent (BYK-3 02 manufactured by BYK-Chemie) at a weight ratio (polyarylate:trichloroethane:leveling agent) of 15:85:0.01.

The casting solution (A) was applied onto the surface of a polyethylene terephthalate film and dried at 110°C for 10 minutes, followed by the peeling of the polyethylene terephthalate film. Thus, a resin film (I) having a thickness of 25 µm was obtained. After that, the resultant resin film (I) was subjected to annealing treatment at 150°C for 10 minutes.

Amixed solution (resin solution for forming an adhesion layer) obtained by mixing an epoxy-based resin (CELLOXIDE 2021P manufactured by Daicel Corporation), an oxetane-based resin (ARON OXETANE OXT-221 manufactured by TOAGOSEI CO., LTD.), a polymerization initiator (ADEKA OPTOMER SP-170 manufactured by ADEKA CORPORATION) , and methyl ethyl ketone at a weight ratio (epoxy-based resin:oxetane-based resin:polymerization initiator:methyl ethyl ketone) of 90 : 10:3 : 100 was applied onto the resin film (I) and dried at 40°C for 1 minute to form an applied layer having a thickness of 11 µm on the resin film (I).

Separately, one surface of an inorganic glass measuring 50 µm thick by 10 cm long by 4 cm wide (D263 manufactured by SCHOTT AG) was washed with methyl ethyl ketone, and was then subjected to corona treatment. Subsequently, an epoxy group-terminated coupling agent (KBM-403 manufactured by Shin-Etsu Chemical Co., Ltd.) was applied onto the surface, and was then thermally-treated at 110°C for 5 minutes. The resin film (I) was bonded onto the surface of the inorganic glass subjected to the coupling treatment as described above from the applied layer side. An adhesion layer (thickness: 11 µm) was formed by irradiating the applied layer with UV light (wavelength: 365 nm, intensity: 1, 000 mJ/cm² or more) from a high-pressure mercury lamp to cure the applied layer, and the adhesion layer was thermally treated at 150°C for 15 minutes. The other surface of the inorganic glass was subjected to the same treatments. Thus, a transparent sheet having a total thickness of 122 µm (resin film/adhesion layer/inorganic glass/adhesion layer/resin film) was obtained.

It should be noted that the resin films (I) bonded onto the inorganic glass each measured 10 cm long by 3 cm wide and a portion of the inorganic glass measuring 10 cm long by 1 cm wide was exposed.

### [Example 2]

Amixed solution (resin solution for forming an adhesion layer) obtained by mixing an epoxy-based resin (CELLOXIDE 2021P manufactured by Daicel Corporation), an oxetane-based resin (ARON OXETANE OXT-221 manufactured by TOAGOSEI CO. , LTD.), a photocationic polymerization initiator(ADEKA OPTOMER SP-170 manufactured by ADEKA CORPORATION) , and methyl ethyl ketone at a weight ratio (epoxy-based resin:oxetane-based resin:photocationic polymerization initiator:methyl ethyl ketone) of 90:10:3:100 was applied onto a polyethylene naphthalate film having a thickness of 25 µm (Teonex Q51DW manufactured by Teijin DuPont Films Japan Limited). After that, the solution was dried at 40°C for 1 minute. Thus, an applied layer having a thickness of 11 µm was formed on the polyethylene naphthalate film. Next, the applied layer was brought into a semi-cured state by irradiating the side of the applied layer opposite to the polyethylene naphthalate film with UV light (5 mJ/cm² or less) .

Separately, one surface of an inorganic glass measuring 50 µm thick by 10 cm long by 4 cm wide (D263 manufactured by SCHOTT AG) was washed with methyl ethyl ketone, and was then subjected to corona treatment. Subsequently, an epoxy group-terminated coupling agent (KBM-403 manufactured by Shin-Etsu Chemical Co., Ltd.) was applied onto the surface, and was then thermally treated at 110°C for 5 minutes. The polyethylene naphthalate film was bonded onto the surface of the inorganic glass subjected to the coupling treatment as described above from the applied layer side. Anadhesion layer (thickness: 11 µm) was formed by thermally treating the applied layer at 150°C for 15 minutes to cure the applied layer. The other surface of the inorganic glass was subjected to the same treatments. Thus, a transparent sheet having a total thickness of 122 µm (resin film/adhesion layer/inorganic glass/adhesion layer/resin film) was obtained.

It should be noted that the resin films (polyethylene naphthalate films) bonded onto the inorganic glass each measured 10 cm long by 3 cm wide and a portion of the inorganic glass measuring 10 cm long by 1 cm wide was exposed.

### [Example 3]

A transparent sheet having a total thickness of 130 µm (resin film (25 µm) /adhesion layer (15 µm) /inorganic glass (50 µm) /adhesion layer (15 µm)/resin film (25 µm)) was obtained in the same manner as in Example 1 except that the thickness of each adhesion layer was set to 15 µm.

### [Example 4]

A solution of terephthaloyl chloride (19.29 g, 0.095 mol) and isophthaloyl chloride (1.02 g, 0.005 mol) in 60 mL of methyl ethyl ketone was added to a stirred mixture of 4,4'-hexafluoroisopropylidene diphenol (23.53 g, 0.07 mol), 4,4'-(2-norbornylidene)bisphenol (8.4 g, 0.03 mol), and triethylamine (22.3 g, 0.22 mol) in 100 mL of methyl ethyl ketone at 10°C. After the addition, the temperature of the solution was increased to room temperature, and then the solution was stirred for 4 hours under nitrogen. During the stirring, triethylamine hydrochloride precipitated in a gelatin form, and as a result, the solution started to have viscosity. After that, the solution was diluted with 160 mL of toluene. The solution was washed with dilute hydrochloric acid (200 mL of a 2% acid), and was then washed with 200 mL of water three times. After that, the solution was vigorously stirred and poured into ethanol so that a bead-like resin was precipitated. The resin was collected and dried at 50°C. The glass transition temperature of the resin measured by differential scanning calorimetry was 270°C.

A casting solution (C) was obtained by mixing the resultant resin, cyclopentanone, and a leveling agent (BYK-302 manufactured by BYK-Chemie) at a weight ratio (resin:cyclopentanone:leveling agent) of 10:90:0.01.

The casting solution (C) was applied onto the surface of a polyethylene terephthalate film and dried at 110°C for 10 minutes, followed by the peeling of the polyethylene terephthalate film. Thus, a resin film (II) having a thickness of 30 µm was obtained. After that, the resultant resin film (II) was subjected to annealing treatment at 150°C for 10 minutes.

A transparent sheet having a total thickness of 132 µm (resin film (30 µm) /Adhesion layer (11 µm)/inorganic glass (50 µm) /adhesion layer (11 µm)/resin film (30 µm)) was obtained in the same manner as in Example 1 except that the resin film (II) was used instead of the resin film (I).

### [Example 5]

The casting solution (C) was applied onto the surface of a polyethylene terephthalate film and dried at 110°C for 10 minutes, followed by the peeling of the polyethylene terephthalate film. Thus, a resin film (III) having a thickness of 45 µm was obtained. After that, the resultant resin film (III) was subjected to annealing treatment at 150°C for 10 minutes.

A transparent sheet having a total thickness of 106 µm (resin film (45 µm)/adhesion layer (11 µm)/inorganic glass (50 µm)) was obtained in the same manner as in Example 1 except that the resin film (III) was used instead of the resin film (I) and the resin film (III) was bonded onto only one side of the inorganic glass.

### [Comparative Example 1]

The resin film (I) produced in Example 1 was used as a resin film.

Amixed solution (resin solution for forming an adhesion layer) obtained by mixing 100 parts by weight (solid content) of a rubber particle-dispersed epoxy resin (KANE ACE MX951 manufactured by KANEKA CORPORATION) and 3 parts by weight of a photocationic polymerization initiator (ADEKA OPTOMER SP-170 manufactured by ADEKA CORPORATION) was applied onto the resin film (I) and dried at 40°C for 1 minute to form an applied layer having a thickness of 15 µm on the resin film (I).

Separately, one surface of an inorganic glass measuring 50 µm thick by 10 cm long by 4 cm wide (D263 manufactured by SCHOTT AG) was washed with methyl ethyl ketone, and was then subjected to corona treatment. Subsequently, an epoxy group-terminated coupling agent (KBM-403 manufactured by Shin-Etsu Chemical Co., Ltd.) was applied onto the surface, and was then thermally treated at 110°C for 5 minutes. The resin film (I) was bonded onto the surface of the inorganic glass thus subjected to the coupling treatment from the applied layer side. An adhesion layer (thickness: 15 µm) was formed by irradiating the applied layer with UV light (wavelength: 365 nm, intensity: 1, 000 mJ/cm² or more) from a high-pressure mercury lamp to cure the applied layer, and the adhesion layer was thermally treated at 150°C for 15 minutes. The other surface of the inorganic glass was subjected to the same treatments. Thus, a transparent sheet having a total thickness of 130 µm (resin film/adhesion layer/inorganic glass/adhesion layer/resin film) was obtained.

It should be noted that the resin films (I) bonded onto the inorganic glass each measured 10 cm long by 3 cm wide and a portion of the inorganic glass measuring 10 cm long by 1 cm wide was exposed.

### [Comparative Example 2]

A transparent sheet having a total thickness of 160 µm (resin film (25 µm) /adhesion layer (30 µm) /inorganic glass (50 µm) /adhesion layer (30 µm)/resin film (25 µm)) was obtained in the same manner as in Comparative Example 1 except that the thickness of each adhesion layer was set to 30 µm.

### [Comparative Example 3]

A transparent sheet having a total thickness of 110 µm (resin film (25 µm) /adhesion layer (5 µm) /inorganic glass (50 µm) /adhesion layer (5 µm)/resin film (25 µm)) was obtained in the same manner as in Example 1 except that the thickness of each adhesion layer was set to 5 µm.

### [Comparative Example 4]

A transparent sheet having a total thickness of 160 µm (resin film (25 µm) /adhesion layer (30 µm) /inorganic glass (50 µm) /adhesion layer (30 µm)/resin film (25 µm)) was obtained in the same manner as in Example 1 except that the thickness of each adhesion layer was set to 30 µm.

### [Comparative Example 5]

One surface of an inorganic glass measuring 50 µm thick by 10 cm long by 4 cm wide (D263 manufactured by SCHOTT AG) was washed with methyl ethyl ketone, and was then subj ected to corona treatment. Subsequently, an epoxy group-terminated coupling agent (KBM-403 manufactured by Shin-Etsu Chemical Co. , Ltd.) was applied onto the surface, and was then thermally treated at 110°C for 5 minutes. The casting solution (C) was applied onto the surface of the inorganic glass subjected to the coupling treatment as described above and dried at 110°C for 10 minutes to form a resin layer having a thickness of 45 µm. Thus, a transparent sheet having a total thickness of 95 µm (resin layer (45 µm)/inorganic glass (50 µm)) was obtained.

### <Evaluation>

The transparent sheets obtained in the foregoing were each evaluated by the following methods. Table 1 shows the results.

### (1) Rupture diameter

(a) The transparent sheets obtained in Examples and Comparative Examples were prepared as samples for evaluation.
(b) A crack having a length of 5 mm or less was produced at the center of a longitudinal side end of the exposed portion of each inorganic glass.
(c) The longitudinal side of each sample for evaluation was bent, and the diameter of a circle using the longitudinal side as its circumference when the crack progressed in the exposed portion of the inorganic glass, and further, progressed by 1 cm in a region where a resin or the like was laminated was defined as a rupture diameter. It should be noted that the transparent sheet including the resin film on one side of the inorganic glass (Example 5) was bent so that the resin film side was convex (the resin film side was directed outward).

### (2) External appearance

A defect (local thickness unevenness due to foreign matter) was visually observed from a place distant from the transparent sheet by 30 cm under a 20-W fluorescent lamp. The case where the number of defects per 10 cm² was 3 or less was evaluated as ○, and the case where the number was 4 or more was evaluated as x.

Each of the adhesion layers and resin films constituting the transparent sheets obtained in Examples and Comparative Examples was evaluated for its modulus of elasticity by the following method.

### (3) Modulus of elasticity

A slot-shaped resin sample measuring 50 µm thick by 2 cm wide by 15 cm long was produced, and then its modulus of elasticity was measured with an AUTOGRAPH (AG-I manufactured by Shimadzu Corporation) from an elongation and a stress in the lengthwise direction of the slot-shaped resin sample at 25°C. Test conditions were as described below. A chuck-to-chuck distance was set to 10 cm, and a tension speed was set to 10 mm/min.

**[Table 1]**

| | Thickness of glass (µm) | Resin film | | | Adhesion layer | | External appearance | Rupture diameter (cm) |
|---|---|---|---|---|---|---|---|---|
| | | Thickness | | | Thickness (µm) | Modulus of elasticity (GPa) | | |
| | | Single film (µm) | Total thickness (µm) | Modulus of elasticity (GPa) | | | | |
| Example 1 | 50 | 25 | 50 | 5 | 11 | 2.1 | ○ | 2.3 |
| Example 2 | 50 | 25 | 50 | 6 | 11 | 2.1 | ○ | 2.3 |
| Example 3 | 50 | 25 | 50 | 5 | 15 | 2.1 | ○ | 3 |
| Example 4 | 50 | 30 | 60 | 2.5 | 11 | 2.1 | ○ | 2.5 |
| Example 5 | 50 | 45 | 45 | 2.5 | 11 | 2.1 | ○ | 2.5 |
| Comparative Example 1 | 50 | 25 | 50 | 5 | 15 | 1.0 | ○ | 4 |
| Comparative Example 2 | 50 | 25 | 50 | 5 | 30 | 1.0 | ○ | 7 |
| Comparative Example 3 | 50 | 25 | 50 | 5 | 5 | 2.1 | × | 2.3 |
| Comparative Example 4 | 50 | 25 | 50 | 5 | 30 | 2.1 | ○ | 5 |

As is apparent from Table 1, according to the present invention, the following transparent sheet can be provided. The transparent sheet includes a resin film having a specific thickness on one side, or each of both sides, of an inorganic glass, and includes an adhesion layer having a specific thickness and a specific modulus of elasticity between the inorganic glass and the resin film, and hence even when the inorganic glass and the resin film are bonded onto each other through the adhesion layer, the sheet is excellent in external appearance, prevents the progress of a crack, and the rupture, of the glass, and is excellent in flexibility.

In addition, the transparent sheet of the present invention did not curl not only in the case where the sheet included the resin film on each of both sides of the inorganic glass but also in the case where the sheet included the resin film on one side of the inorganic glass like Example 5. On the other hand, in the case where the resin solution was directly applied onto one side of the inorganic glass like Comparative Example 5, the resin layer shrank upon its drying to cause large curling.

### Industrial Applicability

The transparent sheet of the present invention can be widely used in display elements such as a liquid crystal display, an organic EL display, and a plasma display, and solar cells.

### Reference Signs List

- 10: inorganic glass
- 11, 11': resin layer
- 12, 12': adhesion layer

## Claims

1. A transparent sheet, comprising:
an inorganic glass; and
a resin film bonded onto one side, or each of both sides, of the inorganic glass through an adhesion layer,
wherein:
the inorganic glass has a thickness of from 35 µm to 100 µm;
the adhesion layer has a single-layer thickness of more than 10 µm and (the thickness of the inorganic glass×0.3) µm or less;
the adhesion layer has a modulus of elasticity at 25°C of from 1.2 GPa to 10 GPa; and
a ratio of a total thickness of the resin film to the thickness of the inorganic glass is from 0.9 to 4.

2. A transparent sheet according to claim 1, wherein the modulus of elasticity of the resin film at 25°C is from 1.5 GPa to 10 GPa.

3. A transparent sheet according to claim 1 or 2, wherein the resin film contains a resin having a glass transition temperature of from 150°C to 350°C.

4. A transparent sheet according to any one of claims 1 to 3, wherein the resin film contains a thermoplastic resin.

5. A transparent sheet according to any one of claims 1 to 4, wherein the adhesion layer is formed of a UV-curable resin.

6. A transparent sheet according to any one of claims 1 to 5, wherein the transparent sheet has a total thickness of 150 µm or less.

7. A transparent sheet according to any one of claims 1 to 6, wherein the transparent sheet is used as a substrate for a display element or for a solar cell.

8. A transparent sheet according to any one of claims 1 to 6, wherein the transparent sheet is used as a moisture-proof cover for a display element or for a solar cell.

9. A method of producing a transparent sheet, comprising the steps of:
applying a resin solution for forming an adhesion layer onto an inorganic glass or a resin film to form an applied layer; and
laminating the inorganic glass and the resin film through the applied layer, followed by curing of the applied layer to form an adhesion layer to bond the inorganic glass and the resin film onto each other,
wherein:
the inorganic glass has a thickness of from 35 µm to 100 µm;
the adhesion layer has a single-layer thickness of more than 10 µm and (the thickness of the inorganic glass×0.3) µm or less;
the adhesion layer has a modulus of elasticity at 25°C of from 1.2 GPa to 10 GPa; and
a ratio of a total thickness of the resin film to the thickness of the inorganic glass is from 0.9 to 4.
